# EUROPEAN PATENT APPLICATION

(11) **EP 1 460 738 A2**
(43) Date of publication of application: **22.09.2004**
(21) Application number: 03006488.5
(22) Date of filing: 21.03.2003
(51) Int. Cl.: H01S 5/022, B29C 33/00, H01L 33/00

(54) **Wafer-scale replication-technique for opto-mechanical structures on opto-electronic devices**

(71) Applicant: Avalon Photonics AG, 8048 Zürich (CH)
(72) Inventor: Gimkiewicz, Christiane, CH 8047 Zürich (CH); Gale, Michael T., CH 8907 Wettswil a.A. (CH); Moser, Michael, CH 5400 Baden (CH)
(74) Representative: Grünecker, Kinkeldey, Stockmair & Schwanhäusser Anwaltssozietät

(57) **Abstract**

In a partial UV-casting process carried out on a wafer scale the process of separating the wafer and the mold may significantly be improved by providing elevated temperatures and/or a reduced viscosity of the replication material during and/or immediately before the separation. Thus, even delicate replica features may be obtained. In a preferred embodiment, an organically modified ceramic material is used as the replication material.

## Description

### Field of the present invention

The present invention relates to a wafer scale fabrication process to define optical and/or mechanical elements on processed opto-electronic devices like light emitting diodes (LEDs), vertical cavity surface emitting lasers (VCSELs), photodetectors, and the like.

### Description of prior art

Semiconductor electro-optical devices such as light-emitters (LEDs and lasers) and - detectors have steadily been gaining in importance during the last years, especially as key elements for optical communication systems. One particularly important device is the vertical cavity surface emitting laser (VCSEL), which is emitting light substantially perpendicularly to the wafer surface. This allows among others to test laser devices on a wafer scale, that is, for at least a large number of laser devices still resting on the non-diced wafer. The geometric configuration of the VCSEL, providing the substantially perpendicular emission of the output beam with respect to the substrate surface, allows - in principle - the direct monolithic integration of additional optical elements, such as lenses, mirrors, prisms, and the like, thereby adjusting the beam characteristics in conformity with application specific requirements.

Previously, several attempts have been made to improve the overall device performance and functionality by directly integrating optical functions on VCSELs.

For example, in "On-chip replication of micro-optical structures for VCSEL to fiber coupling", by T. Ammer et al., Proc. SPIE Vol. 440 (2001) 238, the hybrid integration of lens arrays in a single VCSEL chip after wafer dicing, bonding and packaging is described. Although the device characteristics may be adjusted according to design requirements, this method does not allow parallel processing of the devices and necessitates that each individual laser device has to be handled separately, thus increasing overall cost in mass production.

US patent 5,966,399 describes a process, in which a diffractive lens is etched into a silicon nitride (SiN) layer at an emission window of the VCSEL. EP1 035 423 A2 shows a process, where a diffusion-limited etching technique is used to define a refractive lens. In another approach as described in " Vertical-cavity Surface Emitting Lasers with Integrated Refractive Micro-Lenses", by O. Blum et al., Electronics Letters, 31 (1995), 44, polyimide reflow lenses are formed on bottom emitting VCSELs. The processes used in these approaches, such as diffusion-limited etching or the polyimide reflow process are presently not widely used in semiconductor processing and their compatibility to standard process flows as well as their potential for providing for reliable and high yield manufacturing process is considered quite uncertain.

The well-established standard opto-electronic semiconductor processing is based on deposition, photolithograpy and etch techniques to define structures having well-defined, that is, discrete, values for etch depths and the type of materials deposited. The inherently discrete nature of this process sequence is advantageous for fabricating semiconductor circuit elements, but may represent a disadvantage for the fabrication of optical elements as these may often require a gradually varying layer thickness, i.e., a continuous relief, to be optically efficient.

Common manufacturing methods for optical elements are, for example, hot embossing or injection molding. These methods allow the fabrication of smooth optical surfaces but, when applied in a wafer scale process, would have the disadvantage that they may not allow to leave portions of the substrate completely uncovered by the optical material. Residues of the optical material may, however, significantly adversely affect the further processing of the substrate and may thus hamper the completion of the assembly process. For example, scribe lanes or "sawing streets" are required for dicing the wafers into individual chips. Any residual optical material may, however, contaminate the sawing blades and lead to a destruction of the wafer. Furthermore, residues of the optical material may contaminate metal pads required for the subsequent wire bonding of the chips onto a submount, thereby jeopardizing the reliability of the electric connections.

A combination of UV-molding and lithography, which is hereinafter referred to as partial UV-casting, to realize concentrator cones or prisms on detectors has been demonstrated on silicon wafers with a modified mask-aligner and is described in "Micro-optical Elements and Their Integration to Glass and Opto-Electronic Wafers", by P. Dannberg et al., Microsystem Technologies 6, pp. 41-47, 1999.

Although this approach addresses the above mentioned fundamental problem concerning the integration of optical elements in semiconductor devices, a reliable manufacturing process, however, may require that the lithography and the molding is done in one single fabrication step. During this process step the structures must not harden, thus the mold and the soft optical material need to be separated before hardening. It turns out that the adhesion of the soft optical material to the mold and the suction effect when removing the mold from the soft material is a serious problem with the above approaches.

Thus, a need exists for an improved technique for the integration of optical devices onto semiconductor devices, such as VCSELs, photodetectors, and the like that allows the fabrication of a continuous relief, while avoiding or at least reducing one or more of the above described problems.

### Summary of the invention

It is therefore an object of the present invention to provide a technique for a partial UV-casting process, wherein an improved mold including a hard sol-gel material formed on a metal mask, and/or improved removal techniques for separating the mold from a process substrate, and/or cleaning techniques for removing residues of optical material from the mold.

For a better understanding of the following aspects of the present invention some definitions regarding replication techniques may be provided.

A wafer scale replication process as used hereinafter is meant as a replication process that creates a relief in a replication layer, i.e. a UV-curing optical material, on a substrate or a portion thereof prior to the dicing of the substrate, wherein the substrate may have passed several process and test procedures to form thereon opto-electronic devices. Each device formed in the respective portion is modified at the same time. For example, an entire semiconductor wafer may be equipped with micro-optical components, or only one or more dies of the wafer may receive a respective micro-optical component.

The term micro-optical structures or components refers to components that may contain diffractive or refractive surfaces to modify light passing therethrough or being reflected therefrom. The outer diameter of the micro-optical structure may be adapted to opto-electronic devices, chips or groups thereof that are operatively associated with the micro-optical structure.

Micro-mechanical structures may contain surface profiles to serve as alignment features, as pedestal for optical structures, as encapsulation/protection of sensitive areas, and/or as part of the chip package.

An opto-mechanical structure may represent a structure that is a combination of a micro-optical and a micro-mechanical structure.

Opto-electronic devices emit or detect radiation, preferably light in the visible and/or near infrared spectrum. The emitted or detected free-space beam may be perpendicular to the top-surface of the substrate, on which a plurality of devices are formed, may pass through the bottom of the substrate or may be in any inclined direction. Of particular interest here are opto-electronic devices based on silicon or gallium arsenide like VCSEL diodes, laser diodes, LEDs and silicon detectors.

UV-casting or UV-reaction molding refers to the hardening of a liquid replica or optical material between a mold with a negative relief of the desired profile and a substrate. Either mold or substrate have to be transparent for the UV-light. The light hardens the entire film of optical material. UV-casting may be performed at relatively low process temperatures. Therefore, materials with a large difference in the coefficient of thermal expansion can be composed without cracking, delamination or strong substrate bending.

Partial UV-casting refers to a selective hardening of replica material to substantially avoid the contamination of dedicated substrate areas like bond pads or scribe lanes for dicing the substrate. Partial UV-casting can be applied to substantially plane substrates or to substrates having a profile or topography formed thereon. While UV-casting results in a continuous replica film, the partial UV-casting avoids the hardening of the liquid replica material on specific areas.

A mold for partial UV-casting typically has a non-transparent pattern and a UV-transparent pattern.

According to one aspect of the present invention, a method comprises the formation of a UV-curing optical material layer over at least a portion of a substrate and forming a relief in the UV-curing optical material layer by applying a mold having a UV-transparent portion and a UV-blocking portion. Then, the UV-curing optical material layer is exposed to UV radiation through the mold and a viscosity of the UV-curing optical material layer is reduced to remove the mold.

The partial UV-casting performed in accordance with the above aspect of the invention allows to remove the mold from the substrate, whereby due to the reduced viscosity of the optical material a suction effect during the removal is significantly reduced. Therefore, even delicate features may be formed by the partial UV-casting without sacrificing the integrity thereof. Moreover, the amount of material residues within the mold is remarkably lower compared to conventional techniques, thereby improving the reusability of the mold as well as enhancing the efficiency in cleaning the mold.

In a preferred embodiment, the viscosity of the optical material is reduced by heating the UV-curing material layer. The heating may be carried out prior and/or during the removal of the mold. The viscosity reduction by heating allows to use per se highly viscous optical materials, which offer the advantage of a reduced shrinkage and higher hardness after the final curing process.

In one embodiment, a temperature in heating the UV-curing material layer is in the range of 50 °C to 120°C, and more preferably in the range of 60°C to 100°C.

In a preferred embodiment the UV-curing material layer comprises an organic modified ceramic (ORCOMER®) material.

By using the above identified materials in the UV-curing material layer micro-optical components may be obtained that exhibit a long-term stability, while at the same the viscosity reduction prior and/or during the mold removal allows a reliable and reproducible manufacturing process.

In a further preferred embodiment, the method further comprises developing the UV-curing material layer after exposure and removal of the mold at an elevated temperature. The elevated temperature during the development of the exposed UV-curing material layer may improve the removal selectivity and thus the removal efficiency of the UV-curing material at the non-exposed portion. Therefore, the contamination of sensitive areas may be reduced compared to conventional techniques.

In a further embodiment the method comprises the formation of an anti-adhesive layer on a surface facing the UV-curing material layer prior to applying the mold. The anti-adhesive layer may further enhance the efficiency of the removal process. Thus, even isolated structure elements, such as free-standing columns, and the like, having a small footprint may be replicated.

In a further embodiment the anti-adhesive layer comprises a resist layer. The employment of a resist layer allows the replication of delicate features, such as diffractive lenses, and also reduces residues of the UV-curing material adhering to the mold after removal. Moreover, the resist layer facilitates and accelerates the cleaning of the mold.

In a further preferred embodiment, the method comprises forming the mold by UV-casting a negative form of a desired relief on a substrate having formed thereon a metal pattern to define the UV-transparent portion and the UV-blocking portion.

Forming the mold by UV-casting may provide for the possibility to use metal masks as employed in ordinary lithography processes, such as chromium masks, thereby facilitating the process of forming the mold.

In a further embodiment an organically modified ceramic material is used for UV-casting the mold. Thus, the mold is constituted by a hard and durable material that allows a high number of replications to be carried out with a single mold.

In a further embodiment the mold is UV-cast by using an optical material comprising silicone. The silicone in the mold may trap silicone oil, which may improve the anti-adhesion effect when removing the mold without necessitating additional anti-adhesion agents.

In a further preferred embodiment an optical effective dimension of a micro-optical feature formed on the UV-transparent portion is less than a physical dimension thereof.

By configuring the optically effective dimension, such as a lens diameter, smaller than the actual physical dimension of the feature, the mechanical stability of the feature is enhanced and spurious diffractive effects may be reduced, especially when the optically effective dimension is of the order of 100 µm and less.

In a further preferred embodiment, the method further comprises cleaning the mold UV-casting with a UV-transparent dummy substrate so as to cure all of the UV-curing optical material including residues of a previous replication process, and subsequently removing the cured material including the residues.

According to a second aspect of the present invention, a method comprises the formation of a UV-curing optical material layer over at least a portion of a substrate and forming a relief in the UV-curing optical material layer by applying a mold having a UV-transparent portion and a UV-blocking portion. Then, the UV-curing optical material layer is exposed to UV radiation through the mold and the UV-curing optical material layer is heated prior to and/or while removing the mold.

The heat treatment prior to and/or during the removal of the mold may significantly reduce the adhesion of the UV-curing material to the mold and thus facilitate the removal process. Consequently, delicate micro-optical structures may be formed.

In further embodiments, all of the methods specified above may advantageously be combined with the method of the second inventive aspect.

In a third aspect of the present invention, a method comprises forming an anti-adhesion layer in a mold for partial UV-casting. A UV-curing optical material layer is formed over at least a portion of a substrate and a relief in the UV-curing optical material layer is created by applying the mold having a UV-transparent portion and a UV-blocking portion. Then, the UV-curing optical material layer is exposed to UV radiation through the mold, which is then removed, wherein the anti-adhesive layer reduces an adhesion of UV-curing optical material to the mold.

In further preferred embodiments, the viscosity of the UV-curing optical material layer may be reduced and/or the UV-curing optical material layer may be heat treated prior to and/or during the removal of the mold.

Moreover, any of the process variants described with reference to the first and second aspects of the invention may also advantageously be combined with the processes of the third aspect.

According to a further aspect of the present invention, a method of forming a mold for partial UV-casting replication comprises the formation of a negative form of a desired relief, by UV-casting, on a mask including metal portions, wherein an organically modified ceramic material is used for the partial UV-casting.

According to still another aspect of the present invention, a mold for partial UV-casting includes a negative form of a relief, wherein the negative form comprises an organically modified ceramic material.

In a further embodiment, said mold includes a substrate having formed thereon a UV-transparent portion and a UV-non-transparent portion corresponding to a feature structure represented by the relief.

The mold of the present invention may advantageously be used in combination with any of the above described replication methods.
According to a further aspect of the present invention a method of cleaning a mold having formed thereon at least one UV-transparent portion and a UV-blocking pattern, comprises using the mold for a UV-casting process with a UV-transparent substrate, wherein UV radiation is provided through said UV-transparent substrate to cure replication material provided between the UV-transparent substrate and the mold. Moreover the UV-transparent substrate and said mold are separated to , remove the cured replication material from said mold.

By means of this cleaning process, residues of a former partial UV-casting process may efficiently be removed, wherein all of the above specified techniques for facilitating the separation process of the mold and the substrate may also advantageously be used.

Further illustrative embodiments of the present invention will now be described with reference to the accompanying drawings, in which:
Fig. 1 schematically shows a portion of a replication mold prior to forming a negative form of a micro-optical component by means of a master form;
Figs. 2a-2f schematically depict the formation of micro-optical components by means of the replication mold of Fig. 1 in accordance with illustrative embodiments of the present invention; and
Fig. 3 schematically illustrates a single VCSEL element having formed thereon a retractive lens, which may have been manufactured by the wafer scale replication technique as illustrated in Figs. 2a-2f.

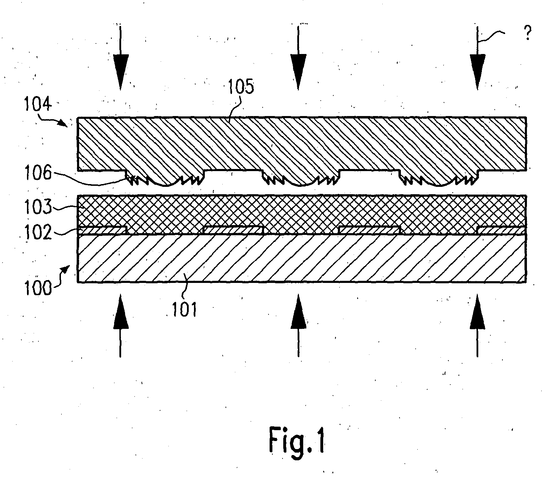

Fig. 1 schematically shows a cross-sectional view of a mask substrate 100 comprising a UV-transparent body 101, for example formed of glass or any other appropriate material, having formed thereon a UV-absorbing or blocking pattern 102, which may, for example, be formed of chromium or any other appropriate material. In one preferred embodiment, the mask substrate 100 may represent a mask as used for photolithography having dimensions that allow to readily mount the mask substrate 100 in a lithography tool as usually used for contact exposure of wafers. Preferably, the mask substrate 100 has dimensions in correspondence with the dimensions of the product substrates receiving micro-optical components by means of partial UV-casting. A layer 103 of transparent replica material is formed on the mask substrate 100 and may comprise, in one preferred embodiment, an organically modified ceramic material as is known as ORMOCER®. In a further preferred embodiment, the layer 103 may comprise silicone.

A master form 104 comprising a transparent body 105 and a plurality of micro-optical elements 106 is positioned above the substrate 100 and aligned thereto In conformity with the non-transparent pattern 102. The master form 104 may be any kind of transparent profile formed, for example, in resist, glass, plastic or silicone. The body 105 of the master form 104 may preferably exhibit the same or larger dimensions than the product substrates to be processed.

The master form 104 may be manufactured by any known techniques such as grayscale photolithography and etching, direct formation of the relief forming the micro-optical elements 106 by laser-aided three-dimensional design tools, and the like. Prior to dispensing the layer 103 onto the mask substrate 100, a pre-alignment of the master form 104 may be performed, followed by a second alignment step after dispensing the layer 103 and bringing the same in contact with the master form 104. In other embodiments, depending on the accuracy of the alignment process, the pre-alignment or the second alignment step may suffice to accurately position the master form 104 with respect to the mask substrate 100. After the master form 104 is brought into contact with the layer 103 and an UV exposure 106 is carried out from the backside of the master form 104. After the exposure 106, which may last from approximately 1-30 seconds depending on the specific composition of the layer 3, the intensity of the exposure 106, and the like, the master form 104 and the mask substrate 100 are separated, and the layer 103 is dried and subsequently hard-baked so as to stabilize the relief formed in the layer 103. The process of separating the master from' 104 and mask substrate 100 may be assisted by heating' the layer 103 and/or reducing the viscosity thereof, as will be described in more detail with reference to Figs. 2a-2f. Depending on the type of material used for the layer 103, an anti-adhesion layer comprising, for instance, oil, photoresist, and the like may be formed on the layer 103 having formed therein the relief corresponding to a negative form of the master form 104. In one embodiment, when the layer 103 is substantially comprised of silicone, a certain amount silicone oil may be captured inside the material of the layer 103, and may act as an anti-adhesion layer in future replication processes using the structured layer 103 as a mold. Preferably, the mask substrate 100 having formed thereon a silicone relief may be stored in an inert ambient prior to usage, such as a nitrogen atmosphere, to avoid any degradation of the anti-adhesion effect. When the layer 103 substantially comprises an organically modified ceramic material, excellent durability of the relief formed in the layer 103 is obtained due to the superior hardness of the organically modified ceramic material compared to, for example, silicone.

With reference to Figs. 2a-2f, further illustrative embodiments in forming micro-optical components on product substrates by partial UV-casting in accordance with the present invention will now be described.

In Fig. 2a, an opto-electronic device 200 comprises a substrate 201 and a plurality of opto-electronic elements 202, which may be provided in the present case as VCSEL elements. The individual VCSEL elements 202 are separated from each other by contact regions 203. A mask substrate, such as the substrate 100 shown in Fig. 1, is positioned in an opposing relationship to the device 200, wherein for the sake of simplicity a corresponding alignment tool, such as a mask aligner, is not shown.

Thus, the mask substrate 100 may comprise a UV transparent body 101 and a UV blocking pattern 102. Moreover, a UV transparent mold 110 is formed on the mask substrate 100, wherein the mold 110 may comprise a material and have corresponding anti-adhesion characteristics as described above with reference to Fig. 1. A microscope 210 may be provided so as to align the mask substrate 100 with respect to the device 200.

Prior to mounting the device 200 on a respective alignment tool (not shown), the substrate 201 may be prepared to substantially remove any grease, wax or oil from the surface thereof. Then, alcohol and an adhesion promoter may be spun onto the substrate 201 and the device 200 may be dried. After mounting the device 200 on an appropriate chuck (not shown) and aligning the mask substrate 100 and the device 200, an optical replication material, such as an organically modified ceramic material, may be dispensed on the substrate 201.

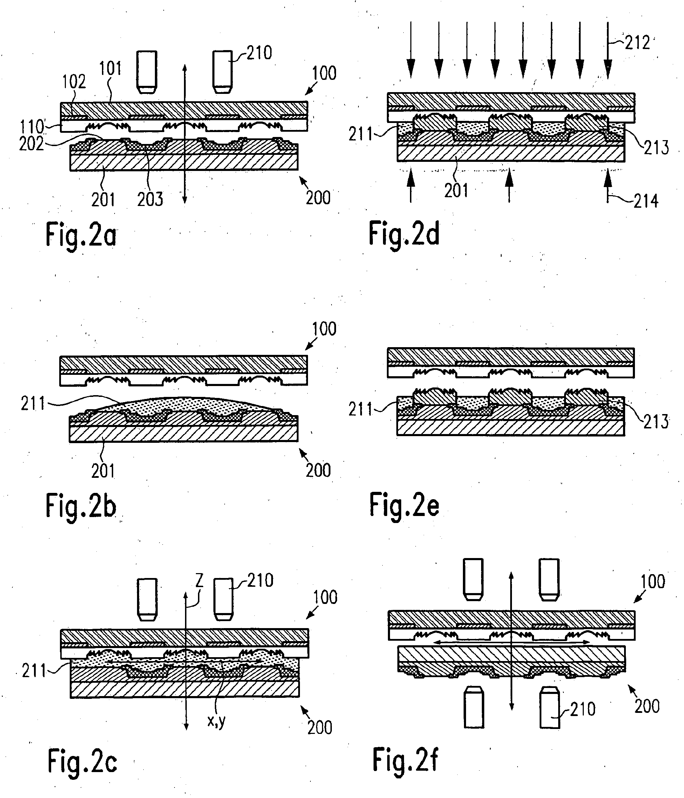

Fig. 2b schematically shows the opto-electronic device 200 after having formed thereon an optical replication material 211. Subsequently, the mask substrate 100, that is, the mold 110, and the substrate 201 are brought into contact and a second alignment step may be carried out so as to finely adjust the mask substrate 100 and the substrate 201 in lateral dimensions x and y as well as in the height direction z.

Fig. 2c schematically shows the opto-electronic device after completion of the second alignment step. It should be noted that the corresponding alignment tool (not shown) may be equipped so as to provide the required alignment precision in the z, x and y directions. The alignment in the x and y directions may be accomplished by corresponding alignment marks formed on the substrate 201 and the mask substrate 100, whereas the z-alignment may be accomplished by mechanical means.

As shown in Fig. 2d, UV light 212 is provided from the backside of the mask substrate 100 to cure exposed portions 213 of the optical replication material 211.

Thereafter, the optical replication material 211 including the exposed portions 213 is heated, for example by applying heat 214 to the substrate 201 to reduce the viscosity and/or reduce the adhesion of the optical replication material 211, 213 to the mold 110. In one embodiment, the substrate 201 and the mask substrate 100 are inserted into an oven, wherein heat is substantially, transferred via the substrate 210 to the optical application material 211, 213. Typically, most of polymeric materials that may be used as an optical replication material show a reduced viscosity and/or a reduced adhesion at elevated temperatures. For example, with a temperature in the range of approximately 50-120°C, and more preferably from about 60-100°C, the viscosity and/or the adhesion of the optical replication material 211, 213 is sufficiently reduced so as to substantially separate the mold 110 and the optical replication material 211, 213 without deteriorating the relief of the exposed portions 213. In other embodiments, the heat 214 may be transferred to the optical replication material 211, 213 via a hot plate, wherein, however, the increased mass of the mask substrate 100 including the mold 110 compared to the total mass of the substrate 201 may require prolonged heating times compared to an oven process range of about 5-12 minutes - or more preferably from about 6 minutes to 10 minutes - for an oven process may be appropriate. Depending on the type of optical replication material 211 used, the parameters of heating process, that is duration and temperature, have to be selected so as to prevent a thermal activation of the non-cured optical replication material 211. Moreover, duration and temperature of the heating process may be selected in conformity with the type of material used in the mold 110 so as to substantially prevent thermal degradation thereof. For instance, if the mold 110 comprises silicone, the temperature during the heating process may be maintained well below 100°C. While heating the optical replication material 211, 213 or immediately after the heating process, the substrate 210 and the mask substrate may be separated by applying a sharp thin edge and lifting off the substrate 210 while the mask substrate 100 is kept in a fixed position. Due to the reduced viscosity and/or reduced adhesion, even delicate features such as diffractive lenses may be substantially formed without any damage. In other embodiments, other substances may be added to the replication material 211 prior to dispensing the same on the substrate 201, which act as viscosity modifier. For instance, one or more viscosity modifier may be added that significantly reduce the, viscosity of the material layer 211 at only slightly elevated temperatures of, for instance, 5-10°C above the actual process temperature, thereby shortening the heat treatment and enhancing the separation process.

Fig. 2e schematically shows the opto-electronic device 200 after separation from the mold 110. As previously noted, the mold 110 may have formed thereon an anti-adhesion layer, which may also assist in reliably separating the substrate 201 and the mold 110. In one preferred embodiment, when the mold 110 comprises organically modified ceramic material, a photoresist layer may be formed on the mold 110 that acts as an anti-adhesion layer during the separation of the substrate 201 and the mold 110 and which may also assist in cleaning the mold 110. A positive photoresist undergoes a photoreaction while it is illuminated by UV radiation. If a post-exposure bake is immediately performed after the illumination, bubbles of diffused water on the surface of the resist are generated that then assist in lifting off the cured optical replication material during the separation step after the thermal treatment.

After the separation, the substrate 210 is immersed in a developer bath to remove the non-cured optical replication material 211 while maintaining the exposed portions 213. In a preferred embodiment, the developer bath is maintained at elevated temperatures, for example in the range of 60-100°C to enhance the efficiency and selectivity in removing the non-cured material 211. Advantageously, a stirrer may be operated during the developing process to further accelerate the material removal.

Finally, the substrate 201 is purged and dried and subsequently heat-treated to achieve the finally required hardness of the portions 213.

In the above-described sequence, micro-optical components are formed on the top side of the substrate 201. The present invention is, however, also applicable to opto-electronic devices 200 requiring formation of micro-optical components at the backside of the substrate 201.

Fig. 2f schematically shows a corresponding arrangement in which the mask substrate 100 and the device 200 are correspondingly aligned by the microscope 210 from the bottom side. In order to facilitate the alignment procedure, the microscope 210 may include the capability of storing images during the alignment process. The further processing may be carried out as described with reference to Figs. 2b-2e.

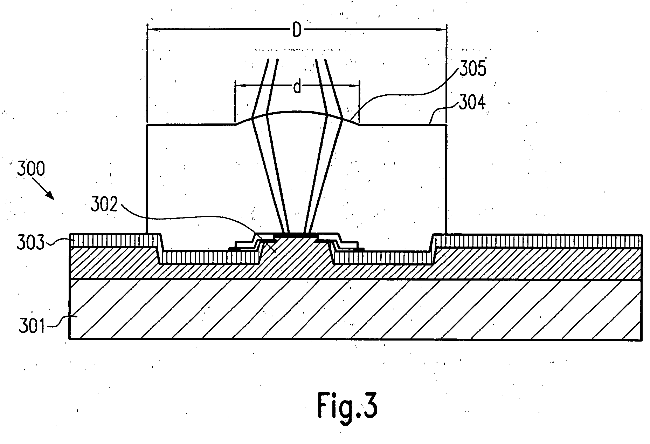

Fig. 3 schematically shows an opto-electronic device 300 having formed thereon a micro-optical component that may be formed in accordance with the process sequence described with reference to Figs. 2a-2f. An opto-electronic device 300 comprises a substrate 301 having formed thereon an opto-electronic element 302 which, in the present example, is to represent a VCSEL diode. Contact portions 303 provide electrical contact to the VCSEL diode 302. A micro-optical component 304, in the form of a refractive lens 305 in the present example, is formed over the VCSEL diode 302, wherein lateral dimensions, indicated by D, of the micro-optical component 304 significantly exceed lateral dimensions, indicated by d, of the refractive lens 305. That is, the physical size of the component 304 is larger than an optically effective size of the refractive lens 305. A corresponding arrangement increases the overall stability of the micro-optical component 304 and also reduces diffraction effects, especially when the diameter d is less than approximately 100 µm. In typical embodiments, the lateral physical dimension D may be in the range of approximately 50-200 µm, whereas the optically effective diameter d may range from approximately 10-100 µm. Typically, a height of the micro-optical component 304 may range from approximately 50-200 µm.

Due to the improved process sequence of the present invention as, for example, described above, any type of micro-optical components may be formed, even if the compound included delicate features, such as Fresnel rings, isolated lines or columns, closely spaced structures, and the like.

After the replication process is completed so as to obtain a micro-optical component such as the component 304, the mold, such as the mold 110 or a mold used for obtaining the refractive lens 305, typically has to be cleaned since residues of the optical replication material may adhere to the mold. For instance, if the mold is substantially comprised of silicone, in one embodiment the following procedure, referred to as clean print, may be applied. A transparent dummy substrate may be used to make another UV-casting with additional, newly supplied replication material on this substrate by means of, the mold to be cleaned. Thereby, the entire optical replication material may be illuminated through the transparent dummy substrate so that the former residual, optical replication material and the newly applied material are cured and can be removed afterwards in a similar manner as is described with reference to Figs. 2a-2f. Thereby, the oil trapped at the contact surface of the silicone mold 110 may further facilitate the separation. Moreover, the above criteria regarding the viscosity reduction and/or the heat treating also apply in this clean-print process.

In other embodiments, when a substantially oil-free optical replication material, such as an organically modified ceramic material, is used to obtain a harder and more accurate structural reproduction of micro-optical components, it may be advantageous to apply a process that is similar to the development process previously described. That is, the mold may be placed in a bath at an elevated temperature, preferably with a stirrer operating during the bath, so as to accelerate the removal of the optical replication material after separation of the mold and the previously performed replication substrate. Then, the mold may be washed in alcohol and dried. As previously noted, an anti-adhesion layer may have been spin-coated or otherwise formed onto the mold prior to performing a partial UV-casting process, wherein in one particular embodiment a photoresist may be used as the anti-adhesion layer. While the mold is cleaned in the solvent baths, the photoresist will also be removed and a new resist layer may be applied for a subsequent replication process for a product substrate.

In the embodiments described above with reference to Fig. 2a - 2d and 3, VCSEL elements are described that receive micro-optical components by the partial UV-casting in accordance with the present invention. The embodiments previously described may also advantageously be used with other semiconductor devices, especially with detectors and imaging devices fabricated on the basis of silicon or any other semiconductor materials and compositions thereof-to provide any desired optical components thereon to obtain the required functionality of the silicon detectors and imaging devices.

## Claims

1. A method comprising:
forming of a UV-curing optical material layer over at least a portion of a substrate,
forming a relief in the UV-curing optical material layer by applying a mold having a UV-transparent portion and a UV-blocking portion,
exposing the UV-curing optical material layer to UV radiation through the mold, and
reducing a viscosity of the UV-curing optical material layer to remove the mold.

2. The method of claim 1, wherein the UV-curing material layer comprises an organic modified ceramic (ORCOMER®) material.

3. The method of claim 1 or 2, further comprising developing the UV-curing material layer at an elevated temperature after exposure and removal of the mold.

4. The method of any of claims 1 to 3, further comprising forming a resist layer as an anti-adhesive layer on a surface facing the UV-curing material layer prior to applying the mold.

5. The method of any of the claims 1 to 4, wherein said substrate has formed thereon an opto-electronic component in form of a light emitting device and/or a radiation detector and/or an imaging device.

6. A method comprising:
forming of a UV-curing optical material layer over at least a portion of a substrate,
forming a relief in the UV-curing optical material layer by applying a mold having a UV-transparent portion and a UV-blocking portion,
exposing the UV-curing optical material layer to UV radiation through the mold, and
heating the UV-curing optical material layer prior to and/or while removing the mold.

7. A method comprising:
forming an anti-adhesion layer in a mold for partial UV-casting, said mold having formed thereon a UV-transparent portion and a UV-blocking portion,
forming a UV-curing optical material layer over at least a portion of a substrate, creating a relief in the UV-curing optical material layer by applying the mold,
exposing the UV-curing optical material layer to UV radiation through the mold, and
removing the mold, wherein the anti-adhesive layer reduces an adhesion of UV-curing optical material to the mold.

8. A method of forming a mold for partial UV-casting replication, the method comprising:
forming a negative form of a desired relief, by UV-casting, on a mask including metal portions, wherein an organically modified ceramic material is used for the partial UV-casting.

9. A mold for partial UV-casting comprising a negative form of a relief, wherein the negative form comprises an organically modified ceramic material.

10. A method of cleaning a mold having formed thereon at least one UV-transparent portion and a UV-blocking pattern, the method comprising:
using the mold for a UV-casting process with a UV-transparent substrate, wherein UV radiation is provided through said UV-transparent substrate to cure replication material provided between the UV-transparent substrate and the mold, and
separating the UV-transparent substrate and said mold to remove the cured replication material from said mold.
